# EUROPÄISCHE PATENTANMELDUNG

(11) **EP 2 500 927 A2**
(43) Veröffentlichungstag der Anmeldung: **19.09.2012**
(21) Anmeldenummer: 12154190.8
(22) Anmeldetag: 07.02.2012
(51) Int. Cl.: H01L 21/288, C25D 5/02, C25D 7/12

(54) **Verfahren zur Abscheidung einer Metallschicht auf einem Halbleiterbauelement und Halbleiterbauelement**

(30) Priorität: 17.03.2011 DE 102011005743
(71) Anmelder: SEMIKRON Elektronik GmbH & Co. KG, 90431 Nürnberg (DE)
(72) Erfinder: Berberich, Sven, 91080 Spardorf (DE)

(57) **Zusammenfassung**

Die Anmeldung betrifft ein Halbleiterbauelement und Verfahren zur galvanischen Abscheidung einer ersten Kontaktmetallschicht auf Kontaktflächen einer Mehrzahl von im Waferverbund vorliegenden Halbleiterbauelementen mit einem pn-Übergang dessen p-dotierter Volumenbereich an eine erste Oberfläche und dessen n-dotierter Volumenbereich an eine zweite Oberfläche angrenzt und dort zweite Kontaktflächen ausbildet Die zweite Oberfläche der Halbleiterbauelemente wird hierbei flüssigkeitsdicht mit einer Kontakteinrichtung eingeschlossen, wobei die Kontakteinrichtung mindestens ein Kontaktelement in elektrischem Kontakt zur zweiten Kontaktflächen der Halbleiterbauelemente und die ein externes Anschlusselement aufweist. Die Halbleiterbauelemente werden mit angeordneter Kontakteinrichtung in ein Galvanikbad mit mindestens einer Elektrode eingebracht und Gleichspannung an die Elektrode und an das Anschlusselement der Kontakteinrichtung angelegt, wodurch sich an den ersten Kontaktflächen der Halbleiterbauelemente Metall der Elektrode abscheidet.

## Beschreibung

### Beschreibung

Die Erfindung beschreibt ein Verfahren zur Abscheidung einer Metallschicht, genauer einer Kontaktmetallschicht auf einer Kontaktfläche eines Halbleiterbauelements, vorzugsweise eines Leistungshalbleiterbauelements und insbesondere von Halbleiterbauelement die matrixartig im Waferverbund vorliegen.

Speziell volumenleitende Leistungshalbleiterbauelemente, aus monokristallinem Halbleitermaterial, weisen zur Verbesserung ihrer elektrischen Eigenschaft, insbesondere der Durchlassverluste zunehmend geringer Dicken auf. Seit langem zum Stand der Technik zählen Leistungsdioden der Spannungsklasse von 1700V mit einer Dicke von ca. 250µm bis 300µm. Zwischenzeitlich bekannt sind auch Leistungsdioden der gleichen Spannungsklasse mit einer um den Faktor zwei bis drei reduzierten Dicke.

Bei derartigen Leistungsdioden, wie auch allen anderen derartigen Leistungshalbleiterbauelementen, sollte die Kontaktmetallschicht derjenigen Kontaktfläche, die nicht mit einem Substrat verbunden ist, zusätzliche Funktionen aufweisen. Beispielhaft sollte diese Kontaktmetallschicht, die häufig mittels Drahtbondverbindungen kontaktiert ist und somit punktuell eingeprägten Strom aufweist, den Strom auf die gesamte zugeordnete Kontaktfläche verteilen um eine homogene Stromverteilung im Leistungshalbleiterbauelement zu erzielen. Ebenso dienen derartige Kontaktmetallschichten in gewissem Umfang auch als Wärmespreizer, die die beim Betrieb entstehende Verlustleistung gleichmäßig über die Oberfläche verteilen und auch an die Umgebung abgeben.

Daher ist es vorteilhaft derartige Kontaktmetallschichten im Vergleich zum lange bekannten Stand der Technik dicker als zur reinen Kontaktierung notwendig, auszubilden. Allgemein bekannt sind eine Vielzahl von verschiedenen Verfahren Metall auf einer Oberfläche abzuscheiden. Wesentliche Parameter sind hierbei die Geschwindigkeit der Abscheidung, die Qualität der abgeschiedenen Schicht und auch die erzielbare Schichtdicke. Häufig führt hier die Optimierung eines Parameters zu einer Verschlechterung eines anderen.

Die hier beschriebenen Halbleiterbauelemente können allerdings auch als polykristalline Photodioden, speziell als Solarzellen für Photovoltaikelement, ausgebildet sein. Hierbei könnte es dann auch vorteilhaft sein anstelle einer Mehrzahl von matrixartig angeordneten Leistungshalbleiterbauelementen nur eine großflächige Photodiode als Halbleiterbauelement vorzusehen.

Der Erfindung liegt die Aufgabe zugrunde ein Verfahren, das eine ausreichend schnelle Abscheidung einer qualitativ hochwertigen Kontaktmetallschicht mit einer Dicke von mehr als vier Mikrometer, vorzugsweise von mehr als acht Mikrometern und ein hiermit hergestelltes Halbleiterbauelement vorzustellen.

Die Aufgabe wird erfindungsgemäß gelöst, durch ein Verfahren mit den Merkmalen des Anspruchs 1 und durch ein Leistungshalbleiterbauelement mit den Merkmalen des Anspruchs 6. Bevorzugte Ausführungsformen sind in den jeweiligen abhängigen Ansprüchen beschrieben.

Ausgangspunkt der Erfindung ist das grundsätzlich bekannte galvanische Abscheideverfahren, das hier angewendet wird um eine erste Kontaktmetallschicht auf einer Mehrzahl von Halbleiterbauelementen abzuscheiden. Es ist hierbei vorteilhaft als Kontaktmetall für diese erste Kontaktmetallschicht Kupfer vorzusehen. Durch geeignet Modifikation des folgenden Verfahren können auch Kontaktmetalle mit einem Anteil von mindestens 90% Kupfer abgeschieden werden.

Das erfindungsgemäße Verfahren geht aus von einer Mehrzahl von Halbleiterbauelementen, vorzugsweise Leistungshalbleiterbauelementen, im Waferverbund. Jedes Halbleiterbauelement weist hierbei mindestens einen pn-Übergang und somit mindestens einen p- (16) und mindestens einen n-dotierten (12, 14) Volumenbereich auf, wobei mindestens ein p-dotierter Volumenbereich an eine erste Oberfläche des jeweiligen Halbleiterbauelements direkt angrenzt und dort mindestens eine erste Kontaktfläche ausbildet.

Ebenso weist jedes Halbleiterbauelement mindestens einen n-dotierten Volumenbereich auf, der an eine zweite Oberfläche angrenzt und dort mindestens eine zweite Kontaktfläche ausbildet. Das einfachste derartig ausgebildete Halbleiterbauelement ist eine volumenleitfähige Diode. Selbstverständlich ist das erfindungsgemäße Verfahren nicht auf Dioden beschränkt, sondern auch für andere volumenleitfähige Halbleiterbauelemente insbesondere auch für Thyristoren und Transistoren geeignet.

Es ist bevorzugt, wenn auf der mindestens einen ersten Kontaktfläche des jeweiligen Halbleiterbauelements bereits eine haftvermittelnde zweite Kontaktmetallschicht vorgesehen ist. Derartige Schichten sind beispielhaft Kontaktmetallschichten aus Nickel oder mit einem Nickelanteil und einer Dicke von weniger als 500nm. Derartige Schichten können vorteilhaft mit einem Aufdampf- oder Sputterverfahren hergestellt sein.

Weiterhin kann es bevorzugt sein auf der zweiten Kontaktfläche eine dritte Kontaktmetallschicht vorzusehen, die gleichartig der zweiten Kontaktmetallschicht ausgebildet und hergestellt sein kann. Es ist hier ebenfalls bevorzugt, wenn diese dritte Kontaktmetallschichten und damit die zweiten Kontaktflächen aller Halbleiterbauelemente des Waferverbunds unmittelbar, also direkt, aneinander angrenzen und somit eine einzige flächige Schicht auf der zweiten Oberfläche des Wafers ausbilden.

Mindestens an der zweiten Oberfläche der Halbleiterbauelemente im Waferverbund, oder kurz des gesamten Wafer, wird in einem nächsten Schritt eine Kontakteinrichtung reversibel angeordnet. Diese Kontakteinrichtung schließt die Rückseite und vorzugsweise auch den Rand des Wafer flüssigkeitsdicht ein. Die Kontakteinrichtung weist, der zweiten Oberfläche des Wafers zugewandt, ein Kontaktelement auf, die vorzugsweise vollflächig an den zweiten Kontaktflächen der Halbleiterbauelemente, bzw. an der dritten Kontaktmetallschicht, anliegt und eine elektrische Verbindung hierzu ausbildet.

Vorzugsweise ist die Kontakteinrichtung nach außen, also in den Bereichen in denen sie nicht an den zweiten Kontaktflächen bzw. am Wafer anliegt elektrisch isoliert. Das Kontaktelement der Kontakteinrichtung ist mit einem Anschlusselement elektrisch leitend verbunden, so dass hierüber die zweiten Kontaktflächen der Halbleiterbauelemente an eine externe Spannungsquelle angeschlossen werden können.

Der nächste wesentliche Verfahrensschritt ist das Einbringen des Wafers mit angeordneter Kontakteinrichtung in ein Galvanikbad. In dem Galvanikbad ist weiterhin eine Elektrode vorgesehen, die das abzuscheidende Kontaktmetall zur Verfügung stellt. Hierbei kann diese Diode vollständig oder auch nur Teile ihrer Oberfläche aus diesem Kontaktmetall bestehen.

Durch Anlegen einer Spannung aus einer Spannungsquelle mit dem Pluspol an der Elektrode und dem Minuspol an dem Anschlusselement der Kontakteinrichtung gehen Ionen des Kontaktmetalls von der Elektrode in Lösung und wandern zu den ersten Kontaktflächen der Halbleiterbauelemente und schlagen sich dort nieder, wodurch die erste Kontaktmetallschicht abgeschieden wird.

Der Strom fließt, bei einer typischen Spannung in der Größenordnung von 10 Volt, bevorzugt zwischen sechs und acht Volt, hierbei vom Pluspol der Spannungsquelle über die Elektrode, die Ionen des Galvanikbades zur den ersten Kontaktflächen, die jeweils mit dem p-dotierten Volumenbereich des Halbleiterbauelements verbunden sind über den jeweiligen pn-Übergang des Halbleiterbauelements zu dessen zweiter Kontaktfläche und über das Kontaktelement der Kontakteinrichtung und deren Anschlusselement zum Minuspol der Spannungsquelle. Wesentlich hierbei ist, dass das jeweilige Halbleiterbauelement volumenleitfähig ist und dass der mindestens eine pn-Übergang je Halbleiterbauelement in der oben beschriebenen Art ausgebildet ist.

Beispielhaft würde durch bei einem Thyristor oder einem Transistor, der einen Steuer- und einen Lastanschluss mit jeweils zugeordneten ersten Kontaktflächen auf der ersten Oberfläche aufweist, der Stromfluss im Galvanikbad den Steueranschluss mit Strom beaufschlagen und hierdurch würde das Halbleiterbauelement leitend werden, wodurch sowohl am Steueranschluss als auch am Lastanschluss eine Abscheidung erfolgt.

Nach dem Abscheiden der ersten Kontaktmetallschicht in gewünschter Dicke von mindestens 4µm, vorzugweise von mindestens 8µm entstehen die erfindungsgemäßen Halbleiterbauelemente, noch im Waferverbund, die anschließend in bekannter Weise vereinzelt werden können.

Die reversible Ausgestaltung der Kontakteinrichtung erlaubt es diese nach dem galvanischen Abscheiden der ersten Kontaktmetallschicht wieder von dem Wafer zu lösen.

Durch die galvanische Abscheidung wird eine erste Kontaktmetallschicht bekanntermaßen hervorragender Qualität abgeschieden. Durch die speziellen Merkmale des Verfahrens, insbesondere durch das Vorsehen der Kontakteinrichtung erlaubt das Verfahren auch einen vergleichsweise einfache und kostengünstige Ausführung und auch eine vollflächige Abscheidung von erstem Kontaktmetall auf den zugeordneten ersten Kontaktflächen.

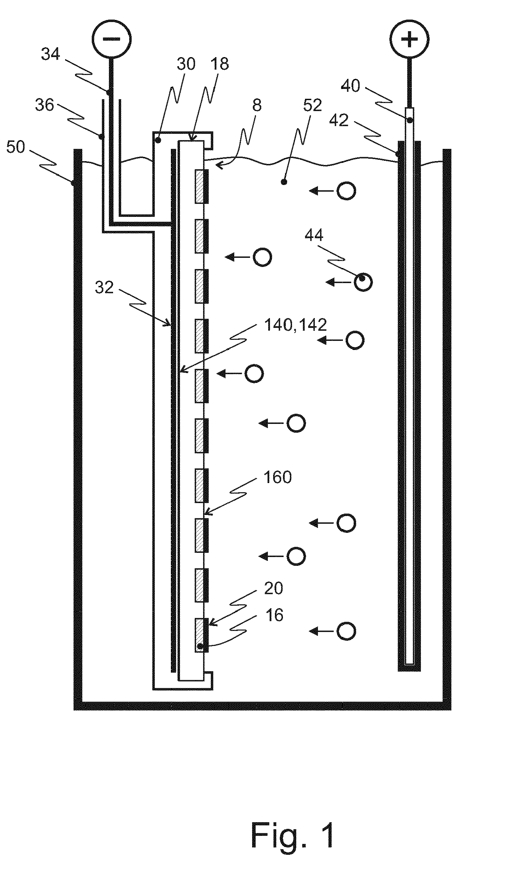

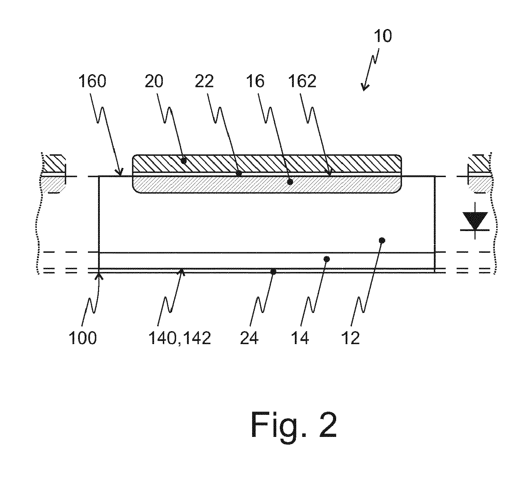

Die erfinderische Lösung wird an Hand der Ausführungsbeispiele gemäß den Fig. 1 und 2 weiter erläutert.

Fig. 1 zeigt eine Vorrichtung zur Anwendung des erfindungsgemäßen Verfahrens.

Fig. 2 zeigt ein erfindungsgemäßes Halbleiterbauelement.

Fig. 1 zeigt eine Vorrichtung zur Anwendung und Erläuterung des erfindungsgemäßen Verfahrens. Dargestellt ist ein Becken 50 mit einem Galvanikbad 52, beispielhaft einer Lösung von Kupfersulfat (CuSO₄) in einer Konzentration der Größenordnung 100 Gramm pro Liter, in dem eine Elektrode 40 vorgesehen ist, die mit dem Pluspol einer Spannungsquelle verbunden ist. Diese Elektrode 40 dient dazu Kupferionen (44) an das Galvanikbad 52 abzugeben und weist hierzu einen Kern aus einem weiteren Metall und eine Ummantelung 42 dieser Kerns mit reinem Kupfer auf. Es kann auch bevorzugt sein die Ummantelung 42 aus einer Mischung mit mindestens 90% Kupfer Anteil und einem anderen Metall vorzusehen.

Ebenfalls dargestellt ist eine Mehrzahl von Halbleiterbauelementen 10, hier von Leistungsdioden, im Waferverbund. Der somit vorliegende Wafer 8 bildet mit Ausnahme seines Randbereiches eine zweidimensionale Matrix von unmittelbar benachbarten Halbleiterbauelementen 10. Das jeweilige Halbleiterbauelement 10, hier die Leistungsdiode weist von ihrer ersten Oberfläche 160, die gleichzeitig die erste Oberfläche des Wafers ist, in das Halbleitermaterial hineinreichend einen p-dotierten Volumenbereich 16 auf, der üblicherweise wannenartig ausgebildet ist und nicht bis an die Grenzen 100, vgl. Fig 2, zur nächsten Leistungsdiode heran reicht. Diese Oberfläche bildet gleichzeitig die einzige erste Kontaktfläche 162 der jeweiligen Leistungsdiode 10 aus. Andere Halbleiterbauelement können eine Mehrzahl funktional gleicher oder unterschiedlicher erster Kontaktflächen aufweisen, die allerdings alle dadurch gekennzeichnet sind, dass sie einem p-dotierten Volumenbereich 16 zugeordnet sind.

Die Rückseite, also die zweite Oberfläche 140 des Wafers 8 und damit der Halbleiterbauelemente 10 weist eine zweite Kontaktfläche 142 auf. Bei dieser Ausgestaltung der Halbleiterbauelemente 10 reicht diese Kontaktfläche 142 bis an die Grenze 100 der benachbarten Leistungsdioden 10, wodurch gewissermaßen eine durchgehende Kontaktfläche des Wafers 8 ausgebildet wird.

Die Rückseite 140 wie auch der Randbereich 18 des Wafers, in manchen Ausgestaltungen auch noch der direkt an diesen Randbereich angrenzende Teil der Vorderseite 160 sind mittels einer Kontakteinrichtung 30 flüssigkeitsdicht eingeschlossen.

Diese Kontakteinrichtung 30 weist auf ihrer, der Rückseite 140 des Wafers 8 zugewandten, Innenseite ein Kontaktelement 32 auf, das mit den zweiten Kontaktflächen 142 aller zu beschichtender Leistungsdioden 10 in elektrischem Kontakt steht, gleichgültig ob diese separiert voneinander oder wie hier als eine gemeinsame Kontaktfläche vorliegen. Zur Galvanikflüssigkeit 52 hin ist die Kontakteinrichtung 30 elektrisch isoliert 36, damit nicht auch auf ihr eine Abscheidung von Kupfer erfolgt und damit ein Kurzschluss des pn-Übergangs über das Galvanikbad vermieden wird.

Weiterhin weist die Kontakteinrichtung 30 ein externes Anschlusselement 34 auf das ebenfalls gegen die Galvanikflüssigkeit 52 elektrisch isoliert zum Minuspol der Spannungsquelle führt. Im Inneren der Kontakteinrichtung 30 ist dieses externe Anschlusselement 34 mit dem Kontaktelement 32 der Kontakteinrichtung 30 elektrisch leitend verbunden.

Die Spannungsquelle ist mit einer Spannung von mindestens 2,5V, vorzugsweise zwischen 6V und 8V, vorzusehen, da im Rahmen des erfindungsgemäßen Verfahrens noch die Durchbruchspannung des pn-Übergangs von typisch 0,7V überwunden werden muss um einen Stromfluss durch die volumenleitfähige Leistungsdiode 10 zu gewährleisten.

In Anwendung des Verfahrens scheiden sich die im Galvanikbad 52 gelösten Kupferionen 44 ausschließlich an den mit den p-dotierten Volumenbereichen 16 verbunden ersten Kontaktflächen 162 der Halbleiterbauelemente 10 ab. An den benachbarten mit einem n-dotierten Volumengebiet 12, vgl. Fig. 2, des Halbleiterbauelements 10 verbundenen Abschnitten der ersten Oberfläche 160 des Wafers 8, bzw. des jeweiligen Halbleiterbauelements 10, findet keine Abscheidung statt. Gemäß dem Stand der Technik sind diese Teile der Oberfläche 160 mit einer isolierenden Schicht, die als Passivierung dient, bedeckt.

Das Verfahren gestattet eine Abscheiderate zwischen 100 nm/Minute und 2000 nm/Minute, wodurch beispielhaft eine Dicke der ersten Kontaktmetallschicht 20 von 10µm nach einer Verweildauer von 5 bis 100 Minuten unter Spannung erreicht wird.

Fig. 2 zeigt ein erfindungsgemäßes Halbleiterbauelement 10, hergestellt nach dem erfindungsgemäßen Verfahren. Zusätzlich ist durch gestrichelte Linien die Lage benachbarter Halbleiterbauelemente 10 im Waferverbund dargestellt. Bei dem Halbleiterbauelement 10 handelt es sich wiederum um eine Leistungsdiode. Diese weist einen monokristallinen n-dotiertem Grundkörper 12 und eine höhere n-Dotierung 14 entlang der Rückseite 140 auf. Beide Gebiete gemeinsam bilden die n-dotierten Volumenbereiche aus, wovon einer im Randbereich der Leistungsdiode 10 bis an die erste Oberfläche 160 heran reicht. Die zweite Oberfläche 140, die Rückseite bildet auf ihrer gesamten Fläche die zweite Kontaktfläche 142 der Leistungsdiode 10 aus. In vorteilhafter Weise ist hier eine dritte Kontaktmetallschicht 24, ausgebildet als lötfähiger Ein- oder Mehrschichtkontakt vorgesehen. Diese dritte Kontaktmetallschicht 24 erleichtert auch den elektrischen Kontakt zum Kontaktelement 32 der Kontakteinrichtung 30.

Der p-dotierte Volumenbereich 16 erstreckt sich von der ersten Oberfläche 160 wannenartig in den Halbleiterkörper hinein und bildet an der ersten Oberfläche die erste Kontaktfläche 162 der Leistungsdiode 10 aus. Direkt auf dieser ersten Kontaktfläche 162 ist in vorteilhafter Weise eine dünne zweite Kontaktmetallschicht 22 vorgesehen, die hauptsächlich der Haftverbesserung der ersten Kontaktmetallschicht 20, hier eine Kupferschicht mit 10µm Dicke dient.

## Patentansprüche

1. Verfahren zur galvanischen Abscheidung einer ersten Kontaktmetallschicht (20) auf Kontaktflächen (162) einer Mehrzahl von im Waferverbund vorliegenden Halbleiterbauelementen (10) **gekennzeichnet durch** die folgenden Schritte:
a) Bereitstellen einer Mehrzahl von Halbleiterbauelementen (10) im Waferverbund, wobei jedes Halbleiterbauelement mindestens einen pn-Übergang und somit mindestens einen p- (16) und mindestens einen n-dotierten (12, 14) Volumenbereich aufweist, mindestens ein p-dotierter Volumenbereich (16) an eine erste Oberfläche (160) des jeweiligen Halbleiterbauelements (10) angrenzt und dort erste Kontaktflächen (162) ausbildet und mindestens ein n-dotierter Volumenbereich (14) an eine zweite Oberfläche (140) des jeweiligen Halbleiterbauelements (10) angrenzt und dort zweite Kontaktflächen (142) ausbildet;
b) Flüssigkeitsdichtes Einschließen mindestens der zweiten Oberfläche (140) der im Waferverbund vorliegenden Halbleiterbauelemente (10) mit einer Kontakteinrichtung (30), die mindestens ein Kontaktelement (32) in elektrischem Kontakt zu zugeordneten zweiten Kontaktflächen (142) der Halbleiterbauelemente (10) und die ein externes Anschlusselement (34) aufweist;
c) Einbringen der Halbleiterbauelemente (10) im Waferverbund mit angeordneter Kontakteinrichtung (30) in ein Galvanikbad (52) mit mindestens einer Elektrode (40), wobei deren Oberfläche zumindest teilweise aus einem ersten Kontaktmetall (42) besteht.
d) Anlegen einer Gleichspannung an die Elektrode (40) und an das Anschlusselement (34) der Kontakteinrichtung (30);
e) Abscheiden von Kontaktmetall (42) ausschließlich an den ersten Kontaktflächen (162) der Halbleiterbauelemente (10).

2. Verfahren nach Anspruch 1, wobei
die zweiten Kontaktflächen (142) aller Halbleiterbauelemente (10) des Waferverbunds direkt aneinander angrenzen und eine gemeinsame Kontaktfläche ausbilden.

3. Verfahren nach Anspruch 1, wobei
die jeweiligen ersten (162) und / oder zweiten (142) Kontaktflächen beim Verfahrensschritt a) bereits eine zweite (22) bzw. dritte (24) Kontaktmetallschicht aufweisen und diese jeweils vorzugsweise eine geringere Dicke als 500nm aufweist.

4. Verfahren nach Anspruch 1, wobei
die erste Metallkontaktschicht (20) eine Dicke von mindestens 4µm, vorzugsweise mindestens 8µm aufweist.

5. Verfahren nach Anspruch 1, wobei
die erste Metallkontaktschicht (20) zu mindestens 90 von 100 aus Kupfer, vorzugsweise vollständig aus Kupfer besteht.

6. Halbleiterbauelement (10) mit mindestens einem pn-Übergang und somit mindestens einem p- (16) und mindestens einem n-dotierten (12, 14) Volumenbereich, wobei mindestens ein p-dotierter Volumenbereich (16) an eine erste Oberfläche (160) des Halbleiterbauelements (10) angrenzt und dort mindestens eine erste Kontaktfläche (162) ausbildet und mindestens ein n-dotierter Volumenbereich (14) an eine zweite Oberfläche (140) des Halbleiterbauelements (10) angrenzt und dort zweite Kontaktflächen (142) ausbildet, wobei auf der mindestens einen ersten Kontaktfläche (162) eine galvanisch abgeschiedene Metallkontaktschicht (20) angeordnet ist

7. Halbleiterbauelement nach Anspruch 6, wobei
die mindestens eine erste Metallkontaktschicht (20) zu mindestens 90 von 100 aus Kupfer, vorzugsweise vollständig aus Kupfer besteht.

8. Halbleiterbauelement nach Anspruch 6, wobei
die mindestens eine erste Metallkontaktschicht (20) eine Dicke von mindestens 4µm, vorzugsweise mindestens 8µm aufweist.
